Europäisches Patentamt

European Patent Office

Office européen des brevets

(19)

(11) Numéro de publication: **0 246 701 B1**

(12) **FASCICULE DE BREVET EUROPEEN**

(45) Date de publication de fascicule du brevet:
**27.11.91**

(51) Int. Cl.⁵: **H03M 3/04**, H04N 7/137

(21) Numéro de dépôt: **87200889.1**

(22) Date de dépôt: **14.05.87**

(54) **Dispositif de codage à modulation différentielle par impulsions codées et dispositif de décodage associé.**

(30) Priorité: 23.05.86 FR 8607392

(43) Date de publication de la demande:
**25.11.87 Bulletin 87/48**

(45) Mention de la délivrance du brevet:
**27.11.91 Bulletin 91/48**

(84) Etats contractants désignés:
**DE FR GB**

(56) Documents cités:
**US-A- 3 580 999**
**US-A- 4 023 199**
**US-A- 4 179 710**
**US-A- 4 307 420**
**US-A- 4 386 366**

**IEEE TRANSACTIONS ON COMMUNICA-
TIONS, vol. COM-29, no. 12, décembre 1981,
pages 1868-1875, IEEE, New York, US; TOS-
HIO KOGA et al.: "Statistical performance
analysis of an interframe encoder for broadcast television signals"**

(73) Titulaire: **TRT TELECOMMUNICATIONS RA-
DIOELECTRIQUES ET TELEPHONIOUES
88 rue Brillat Savarin
F-75013 Paris(FR)**

(84) Etats contractants désignés:
**FR**

Titulaire: **N.V. Philips' Gloeilampenfabrieken
Groenewoudseweg 1
NL-5621 BA Eindhoven(NL)**

(84) Etats contractants désignés:
**DE GB**

(72) Inventeur: **Boisson, Jean-Yves Société Civile
S.P.I.D.
209, rue de l'Université
F-75007 Paris(FR)**

(74) Mandataire: **Chaffraix, Jean et al
Société Civile S.P.I.D. 156, Boulevard Haussmann
F-75008 Paris(FR)**

Rank Xerox (UK) Business Services

## Description

L'invention concerne un dispositif de codage à modulation différentielle par impulsions codées comportant une entrée pour recevoir le signal à coder, un circuit de différence pour fournir un signal de différence formé par un certain nombre d'éléments binaires représentant la différence entre le signal à coder et un signal de prédiction, un circuit de prédiction d'émission pour fournir ce signal de prédiction, un circuit de transcodage d'émission pour réduire le nombre d'éléments binaires du circuit de différence en fonction d'une information de commande pour déterminer une parmi une pluralité de caractéristiques de transcodage préétablies, un circuit de mesure d'activité pour fournir une information d'activité, un circuit de codage statistique à mots numériques de longueur variable pour coder le signal de sortie du circuit de transcodage, un circuit de mémoire tampon pour emmagasiner les mots du circuit de codage statistique et pour les fournir vers la sortie dudit dispositif et un circuit de mesure d'occupation pour fournir une information d'occupation du circuit de mémoire tampon, dispositif comportant en outre un organe de combinaison pour fournir l'information de commande à partir de l'information d'activité et de l'information d'occupation.

Un dispositif de codage de ce genre trouve des applications importantes notamment dans le domaine de la télévision numérique. On pourra à ce sujet se reporter à l'article de PETER PIRSCH intitulé "Design of DPCM Quantizers for Video Signals Using Subjective Tests" et paru en juillet 1981 dans la revue "IEEE TRANSACTIONS ON COMMUNICATIONS, VOL.COM-29, N°7.

On sait que dans ce genre de dispositif on est confronté au problème du débordement du circuit de mémoire dû au circuit de décodage statistique. En effet, il peut arriver que le codage d'une image implique l'utilisation de mot de grande longueur de sorte qu'il arrive plus de données dans le circuit de mémoire qu'il n'en sort.

Pour résoudre cette sorte de problème, il est connu d'agir au niveau du circuit de transcodage dans un sens tel que le circuit de codage statistique fournisse des mots de plus faible longueur (voir par exemple l'article de TOSHIO et autres intitulé : "Statistical Performance Analysis of an Interframe Encoder for Broadcast Television Signals" et paru en décembre 1981 dans la revue IEEE TRANSACTIONS ON COMMUNICATIONS, VOL.COM-29, N°12).

Le brevet US- 4 307 420 enseigne aussi le fait que le circuit de transcodage peut être commandé par une information combinant à la fois l'activité de l'image et l'occupation de la mémoire. Cependant ce brevet ne mentionne pas la présence d'un circuit de codage statistique relié à la sortie du circuit de transcodage comme cela est indiqué dans le brevet US- 4 179 710.

La présente invention propose un dispositif du genre cité dans le préambule qui donne les mesures pour combiner les informations d'activité et d'occupation afin de sauvegarder une image de qualité suffisante dans un plus grand nombre de cas où un risque de débordement est détecté.

Pour cela, ce dispositif est remarquable en ce que l'organe de combinaison comporte des moyens de comparaison pour comparer l'information d'activité avec des informations de seuils afin de fournir l'information de commande, et des circuits de combinaison pour fournir les informations de seuil à partir de l'information d'occupation et d'informations de seuil préétablies.

L'invention concerne aussi un dispositif de décodage associé.

La description suivante en regard des dessins annexés, le tout donné à titre d'exemple, fera bien comprendre comment l'invention peut être réalisée.

La figure 1 montre un dispositif de codage conforme à l'invention.

La figure 2 montre l'allure de caractéristiques de transcodage.

La figure 3 montre comment sont réalisés le circuit de codage statistique, le circuit de mémoire et le circuit de mesure d'occupation faisant partie du dispositif de la figure 1.

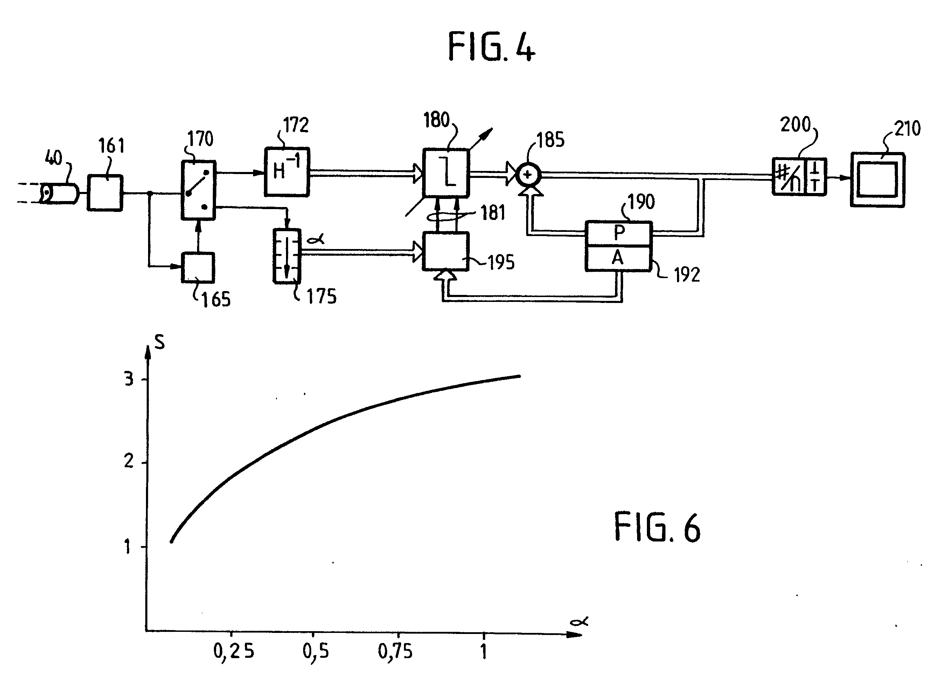

La figure 4 montre un dispositif de décodage conforme à l'invention.

La figure 5 montre comment peuvent être réalisés le circuit de prédiction, le circuit de mesure d'activité et l'organe de combinaison.

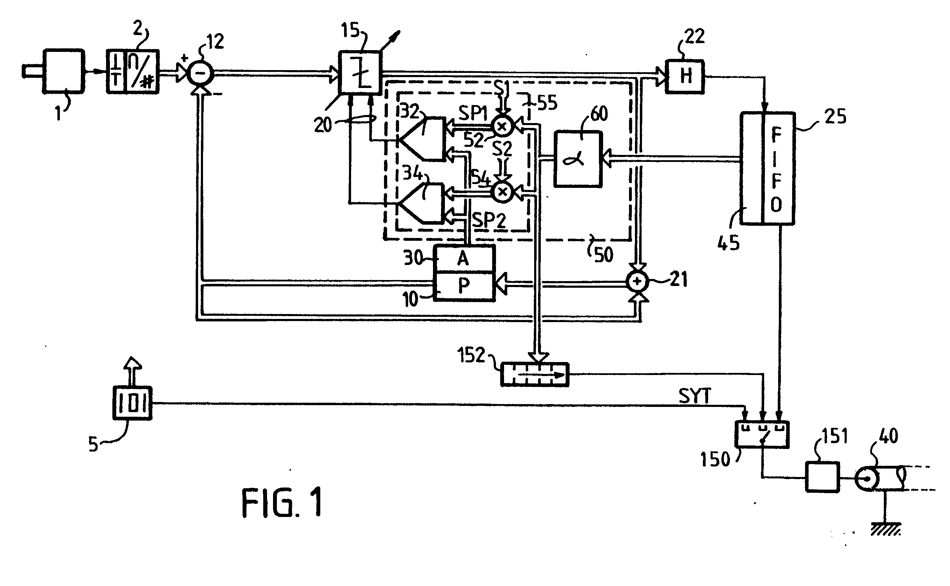

A la figure 1, la référence 1 indique une caméra de télévision ; le signal analogique à sa sortie est codé, sous forme numérique par un codeur échantillonneur-bloqueur 2, à la cadence définie par un circuit d'horloge 5.

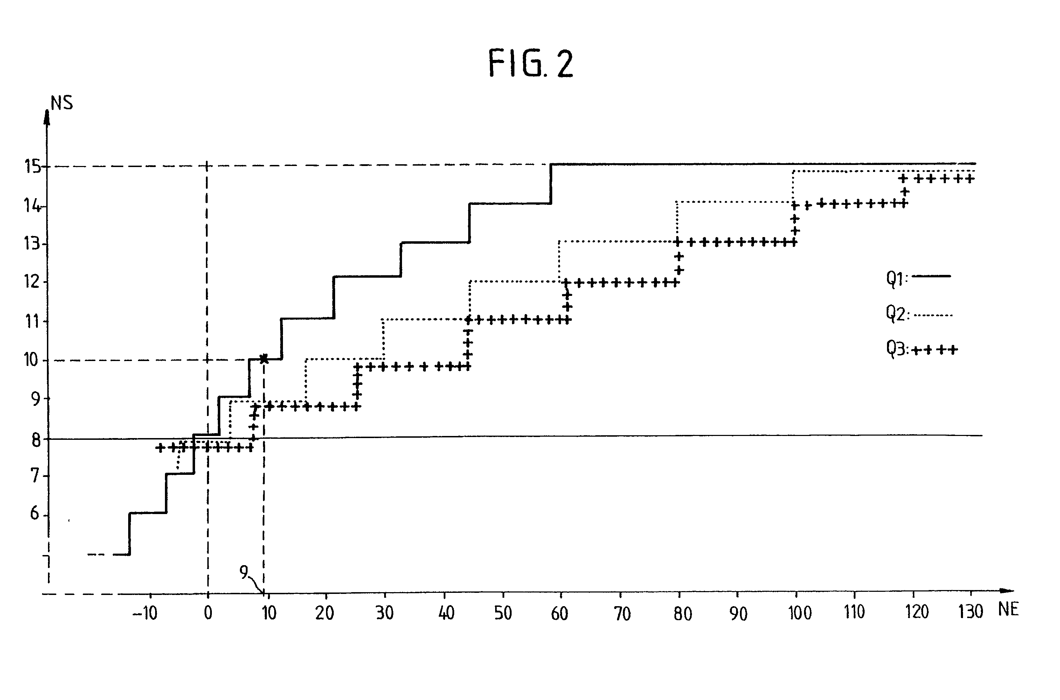

L'échantillon à la sortie du codeur est comparé avec l'échantillon fourni par un circuit de prédiction 10. Pour cette comparaison, on utilise un circuit de différence 12 ; le signal de différence qui en résulte est appliqué à l'entrée d'un circuit de transcodage 15 qui réduit le nombre d'éléments binaires du signal de différence. Cette réduction s'effectue selon des caractéristiques Q1, Q2 et Q3 dont l'allure est montrée en partie à la figure 2. Ainsi, dans l'exemple dont il est question, le signal de différence est codé selon NE sur 511 niveaux (- 255 à + 255) à l'entrée, tandis que le signal à la sortie n'en présente plus que 15, selon NS ; le choix de ces différentes caractéristiques Q1, Q2 et Q3 est déterminé par une information de commande appliquée à une entrée 20. Le code de sortie du circuit de transcodage 15 est appliqué d'une part à l'entrée d'un additionneur 21 recevant en outre sur son autre entrée le signal du prédicteur 10 et d'autre part, à l'entrée d'un circuit de codage statistique 22 qui fait correspondre des mots numériques de courte longueur pour les mots d'entrée arrivant le plus souvent, c'est-à-dire les mots représentant les signaux de différence de faibles valeurs. Ainsi pour NS = 8 on aura un mot d'un élément binaire, pour NS = 9 ou 7 un mot de 3 éléments binaires et pour NS = 10 ou 6 un mot de 5 éléments binaires et ainsi de suite... selon le codage dû à Huffman. On pourra à ce sujet consulter le paragraphe 6.2.3.2. de l'ouvrage intitulé "Digital Image Processing" de R.C. GONZALEZ et P. WINTZ édité en 1977 par ADDISON-WESLEY PUBLISHING Company.

Le code fourni par ce codeur 22 se présente sous forme série à sa sortie et est appliqué à un circuit de mémoire tampon 25 constitué essentiellement par une mémoire du type première donnée entrée, première donnée sortie mieux connue sous le nom de mémoire FIFO.

Pour déterminer la caractéristique de transcodage Q1, Q2 et Q3 offerte par le circuit de transcodage 15, on utilise un circuit de mesure d'activités 30 coopérant avec le circuit de prédiction 10. Les valeurs d'activités élaborées par ce circuit sont comparées à des valeurs de seuils SP1 et SP2 au moyen de comparateurs 32 et 34.

On sait que l'activité définit une transition de luminance entre éléments d'image ; l'activité est d'autant plus forte que la transition est brutale. A une activité forte on associe une caractéristique grossière par exemple Q3 puisqu'il n'est pas nécessaire (voir le premier article cité) de coder avec précision les niveaux situés de part et d'autre de la transition. A une activité faible on associe, donc, une caractéristique fine Q2 ou mieux Q1. Ainsi par le choix de ces caractéristique on essaye de se situer vers les niveaux NS proches de 8 correspondant à des mots de faible longueur élaborés par le codeur d'Huffman 22. Cependent, on peut se trouver dans des cas défavorables où les mots sont très longs et où le débit de transmission qu'autorise le canal de transmission (représenté à la figure 1 par un câble coaxial 40) est insuffisant. Il en découle que le circuit mémoire 25 risque de déborder, ce risque étant apprécié par une information d'occupation élaborée au moyen d'un circuit de mesure d'occupation 45 rattaché au circuit de mémoire tampon 25.

Pour éviter ce débordement, le dispositif de codage comporte, en outre, conformément à l'invention, un organe de combinaison 50 pour fournir l'information de commande de caractéristiques à partir de l'information d'activité et de l'information d'occupation.

Cet organe de combinaison 50 est formé, en plus des comparateurs 32 et 34, de deux multiplieurs 52 et 54 pour multiplier par un facteur $\alpha$ deux valeurs de seuils préétablies S1 et S2 et pour fournir :

SP1 = $\alpha$.S1

SP2 = $\alpha$.S2

Les éléments 32, 34, 51 et 52 font partie d'un ensemble commun 55 que l'on retrouvera dans le circuit de décodage associé à ce circuit de codage. Ce facteur $\alpha$ est établi au moyen d'un circuit de calcul 60 qui effectue l'opération suivante :

$$\alpha(T+1) = \alpha(T) - k.\{\rho B(T) + [B(T) - B(T)]\}$$
où $k = [\alpha(T) - \alpha(T\text{-}1)]/[B(T) - 2B(T\text{-}1) + B(T\text{-}2)]$

et $\rho$ est un coefficient d'amortissement dont la valeur peut être égale à 0,5.

Il convient, dès lors, de noter que les coefficients $\alpha$ sont calculés pour des périodes de temps $\tau$ successives en des instants $i.\tau$ où $i = -\infty, ..., T\text{-}2, T\text{-}1, T$. L'instant $T.\tau$ correspondant à l'instant présent. La durée $\tau$ correspond en pratique à la durée d'une trame d'image. On appelle B(T) le degré de remplissage du circuit mémoire chiffré en nombre d'éléments binaires et considéré à l'instant T, B(T-1) le degré de remplissage à l'instant T-1 et B(T-2) à l'instant T-2. On se propose donc de déterminer $\alpha(T+1)$ qui ramène le degré de remplissage B(T+1) à zéro ou mieux qui le diminue du coefficient d'amortissement $\rho$ pour le ramener à une fraction du degré précédent, c'est-à-dire B(T+1) = (1-$\rho$)B(T).

Pour calculer $\alpha(T+1)$ on admet que les variations de degré de remplissage sont une fonction linéaire de $\alpha$, ce qui permet d'écrire dans le cas présent, avec $\alpha_0$ constante à éliminer :

$$\alpha(T) = k[B(T) - B(T\text{-}1)] + \alpha_0$$

Pour estimer $\alpha(T+1)$ il faut donc que :

$$B(T+1) - B(T) = -\rho B(T)$$

d'où

$$\alpha(T+1) = \alpha(T) - k.[B(T) - B(T\text{-}1)] + k.[-\rho B(T)]$$

et de là, la formule proposée.

Le circuit de calcul 60 établit l'évaluation de $\alpha(T+1)$ uniquement sur la lecture du degré de remplissage du circuit mémoire ; c'est ce degré de remplissage qui constitue, dans cet exemple décrit, l'information d'occupation.

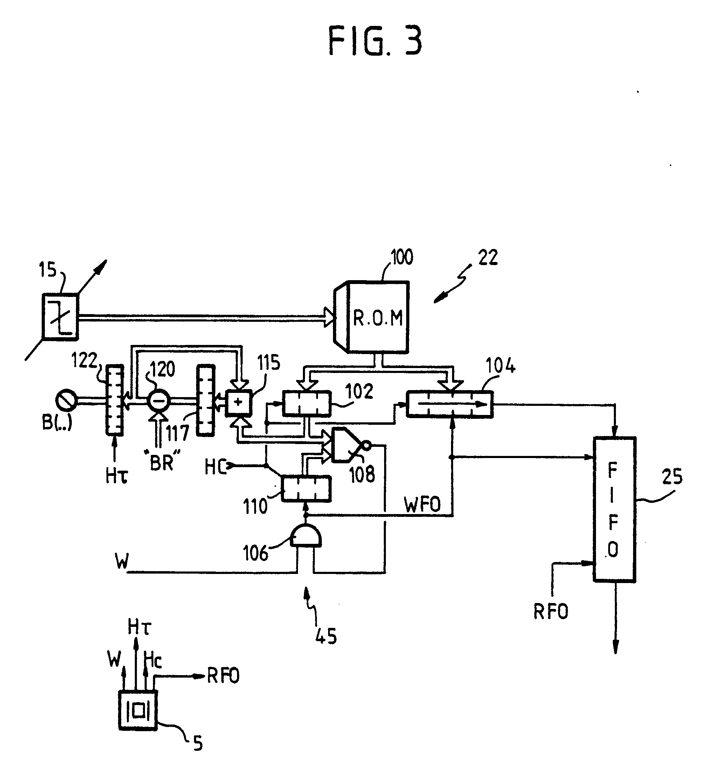

A la figure 3, où l'on a représenté plus en détail le codeur 22 coopérant avec le circuit de mesure d'occupation 45, on montre comment est élaborée l'information d'occupation.

Le codeur 22 est constitué essentiellement par une mémoire morte 100 qui est adressée par le code de sortie du circuit de transcodage 15. Le code à la sortie de cette mémoire est scindé en deux parties : une partie est appliquée aux entrées en parallèle d'un registre 102 et l'autre partie aux entrées en parallèle d'un registre à décalage 104 ; le registre 102 destiné à contenir une valeur indiquant la largeur du mot dans le registre 104. Les commandes de chargement de ces registres 102 et 104 reçoivent un signal HC qui est actif, au même rythme selon lequel l'échantillonnage est effectué par le codeur échantillonneur. La sortie en série du registre à décalage 104 est connectée à l'entrée de la mémoire. L'inscription de cette mémoire s'effectue par un signal WFO au même rythme que le décalage du registre 104. Ce signal WFO provient de la sortie d'une porte ET 106 à deux entrées : la première reçoit des signaux W périodiques dont la cadence est un multiple de la fréquence des signaux HC, ce multiple correspondant à la longueur maximale des codes contenus dans le registre 104. La deuxième entrée de la porte 106 est reliée à la sortie d'un comparateur de codes 108 qui fournit un signal de blocage pour la porte 106 lorsqu'est détectée une égalité de codes continus, d'une part dans le registre 102 et d'autre part dans un compteur 110 comptant les impulsions de signal WFO. Ce compteur est remis à zéro dès que le signal HC est actif.

De cette manière, la mémoire 25 se remplit successivement des éléments binaires constituant chaque mot de longueur variable. Pour obtenir le degré de remplissage de la mémoire 25, on utilise un circuit accumulateur formé d'un additionneur 115 et un registre d'accumulation 117. L'additionneur 115 effectue la somme du contenu du registre 102 avec le contenu du registre 117 diminué d'une valeur "BR". Cette diminution est effectuée par un circuit de soustraction 20. La valeur BR définit le degré de remplissage optimal de la mémoire 25, par exemple, la moitié de sa capacité. Un signal $H\tau$ qui devient actif après chaque période de temps $\tau$ permet le chargement dans un registre 122 du degré de remplissage B(...) utile pour le circuit de calcul 60. On notera que la mémoire 25 se vide au rythme d'un signal de lecture RFO. Pour pouvoir transmettre les informations ainsi codées, on utilise un multiplexeur 150 (voir figure 1) ; ce multiplexeur transmet, via un circuit de transmission de ligne 151, sur le canal de transmission 40 pendant un premier temps un code de synchronisation "SYT" fourni par la base de temps 5 puis, pendant un deuxième temps la valeur $\alpha$ provenant d'un registre à décalage 152 dont les entrées en parallèle sont connectées à la sortie du circuit 60 et enfin, pendant un troisième temps les informations d'image provenant de la mémoire 25, et ceci se reproduit pour chaque trame d'image. Les différents signaux W, $H\tau$, HC et RFO, dont il a été question, proviennent de la base de temps 5.

Le dispositif de décodage conforme à l'invention se compose d'un circuit de réception de ligne 161 dont l'entrée est connectée au canal de transmission 40 et dont la sortie est reliée d'une part à l'entrée d'une base de temps de réception 165 et d'autre part à un démultiplexeur 170 qui est commandé par la base de temps de réception 165 et qui permet de fournir d'une part à un registre 175 la valeur $\alpha$ et d'autre part les différents mots de longueurs variables à un décodeur 172 effectuant l'opération inverse du décodeur 22. Un organe de transcodage 180 effectue l'opération inverse de celle effectuée par le circuit 15, c'est-à-dire l'une des caractéristiques inverses $Q_1^{-1}$, $Q_2^{-1}$, $Q_3^{-1}$. La valeur à prendre sera prise au milieu de chaque palier. Ainsi pour un code NS = 10 correspondra un code NE = 9 pour la caractéristique $Q_1^{-1}$, le choix de l'une de ces caractéristiques étant défini par une information de code appliquée à ses entrées 181. Un circuit additionneur 185 effectue la somme du code de sortie du transcodeur 180 avec le code de sortie à la sortie d'un circuit de prédiction 190 de même structure que le circuit 10 ; on retrouve aussi un circuit de mesure d'activité 192 de même structure que le circuit 30 ; l'indication de la mesure est combinée avec l'information $\alpha$ par le circuit 195 pour fournir l'information de commande de la même manière que l'ensemble 55. Un convertisseur numérique-analogique 200 permet de fournir les informations convenables pour qu'un dispositif de visualisation 210 puisse fonctionner.

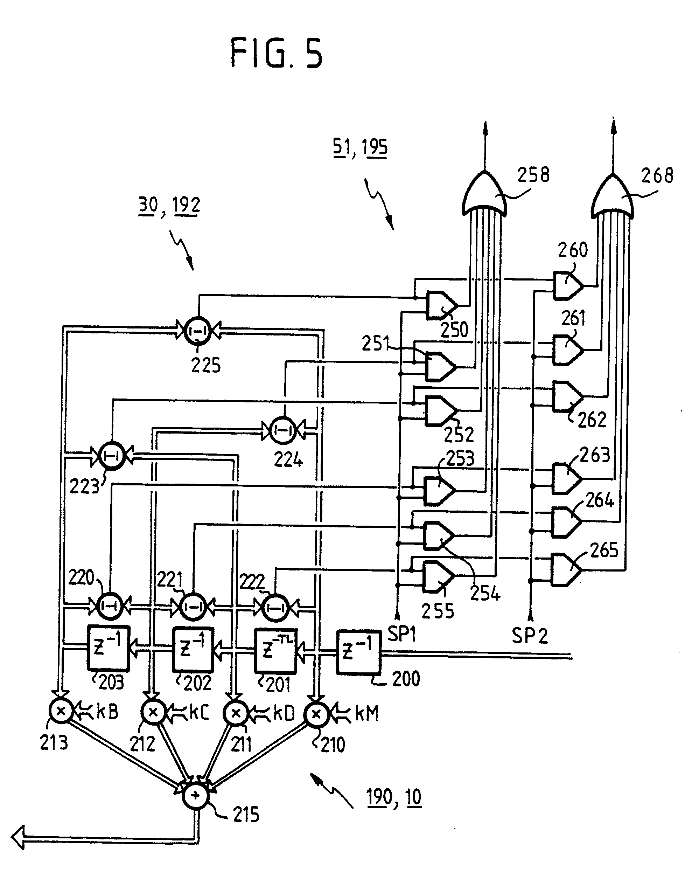

La figure 5 indique un exemple possible de la manière de réaliser le circuit de prédiction avec le circuit de mesure d'activité et la manière d'obtenir l'information de commande. Ces circuits utilisent la luminance des points sur la ligne précédente et des points précédents de la même ligne.

L'ensemble montré à la figure 5 est bâti autour d'un ensemble d'éléments de retard 200, 201, 202 et 203 montés en cascade ; les éléments 200, 202 et 203 apportent un retard d'un élément d'image tandis que l'élément 201 amène un retard équivalent à une ligne d'image diminuée de deux éléments d'image. C'est à partir des différents signaux aux sorties de ces éléments que l'on peut d'une part, effectuer la prédiction et d'autre part, mesurer l'activité.

En ce qui concerne la prédiction, différents multiplexeurs 210, 211, 212 et 213 effectuent respectivement le produit par les coefficients de prédiction KM, KD, KC et KB des signaux aux sorties des éléments 200, 201, 202 et 203 ; un additionneur 215 fournit la valeur de prédiction en effectuant la somme des produits.

En ce qui concerne l'activité on utilise différents opérateurs 220, 221, 222, 223, 224 et 225 qui donnent la valeur absolue de la différence des signaux appliqués à leur entrées. Ces entrées sont branchées à chacune des sorties des éléments 200 à 203. Une première série de comparateurs 250 à 255 détecte si l'un des résultats procurés par l'un des opérateurs 220 à 225 excède la valeur de seuil SP1 ; une porte OU 228 recueille tous les résultats de cette série de comparateurs 250 à 255 pour restituer le premier élément binaire de l'information de commande. Une deuxième série de comparateurs 260 à 265 détecte si l'un des résultats procurés par l'un des opérateurs 220 à 225 excède la valeur de seuil SP2 ; une porte OU 238 recueille tous les résultats de cette deuxième série de comparateurs 260 à 265 pour constituer le deuxième élément binaire de l'information de commande.

Les transcodeurs 180 et 15 sont constitués d'une manière avantageuse par une mémoire morte dont les adresses sont constituées, d'une part pour les poids faibles, par le signal de sortie du circuit de soustraction 15 ou le décodeur 172 et, d'autre part pour les poids forts, par l'information de commande.

A la figure 6 on a représenté comment le facteur $\alpha$ agit sur l'entropie S qui définit la limite inférieure du codage en bit par élément d'image. Ceci donne donc la régulation du débit possible.

**Revendications**

1. Dispositif de codage à modulation différentielle par impulsions codées comportant une entrée pour recevoir le signal à coder, un circuit de différence pour fournir un signal de différence formé par un certain nombre d'éléments binaires représentant la différence entre le signal à coder et un signal de prédiction, un circuit de prédiction d'émission pour fournir ce signal de prédiction, un circuit de transcodage d'émission pour réduire le nombre d'éléments binaires du circuit de différence en fonction d'une information de commande pour déterminer une parmi une pluralité de caractéristiques de transcodage préétablies, un circuit de mesure d'activité pour fournir une information d'activité, un circuit de codage statistique à mots numériques de longueur variable pour coder le signal de sortie du circuit de transcodage, un circuit de mémoire tampon pour emmagasiner les mots du circuit de codage statistique et pour les fournir vers la sortie dudit dispositif et un circuit de mesure d'occupation pour fournir une information d'occupation du circuit de mémoire tampon, dispositif comportant en outre un organe de combinaison pour fournir l'information de commande à partir de l'information d'activité et de l'information d'occupation, caractérisé en ce que l'organe de combinaison comporte des moyens de comparaison pour comparer l'information d'activité avec des informations de seuils afin de fournir l'information de commande, et des circuits de combinaison pour fournir les informations de seuil à partir de l'information d'occupation et d'informations de seuil préétablies.

2. Dispositif de codage à modulation différentielle par impulsions codées selon la revendication 1 pour lequel l'information d'occupation se présente sous la forme B(T) correspondant au degré de remplissage du circuit de mémoire tampon, caractérisé en ce que l'organe de combinaison comporte un circuit de calcul pour effectuer en des instants $i_T$ avec,

$$i = -\infty, ..., T-2, T-1, T :$$
$$\alpha(T+1) = \alpha(T) - k.\{\rho B(T) + [B(T) - B(T-1)]\}$$
où $k = [\alpha(T) - \alpha(T-1)]/[B(T) - 2B(T-1) + B(T-2)]$

et $\rho$ est un coefficient d'amortissement dont la valeur peut
être égale à 0,5,
et en ce que les circuits de combinaison sont des multiplieurs pour effectuer les produits des informations de seuil préétablies avec cette valeur $\alpha$.

3. Dispositif de décodage à modulation associé à un dispositif de codage selon l'une des revendications 1 à 2 dans lequel il est prévu des moyens pour transmettre une information de décodage dérivée de l'information d'occupation, caractérisé en ce qu'il comporte un circuit d'extraction de l'information de décodage, un décodeur pour décoder les mots numériques de longueur variable, un circuit de transcodage de réception pour rétablir en fonction d'une information de commande de réception le transcodage du circuit de transcodage d'émission, un circuit d'addition pour additionner le signal de sortie du circuit de transcodage de réception avec le signal fourni par un circuit de prédiction de réception et pour fournir ainsi le signal décodé d'une part à l'utilisateur et d'autre part à l'entrée du circuit de prédiction de réception, un circuit de mesure d'activité de réception et un organe de combinaison pour fournir l'information de commande de réception à partir de l'information d'activité et de l'information d'occupation.

**Claims**

1. A differential pulse code modulation encoding arrangement comprising a input for receiving the signal to be encoded, a difference circuit for supplying a differential signal formed by a given number of binary elements representing the difference between the signal to be encoded and a prediction signal, a transmission prediction circuit for supplying this prediction signal, a transmission transcoding circuit for reducing the number of binary elements of the difference circuit as a function of control information for determining one out of a plurality of pre-established transcoding characteristics, an activity measuring circuit for supplying activity information, a statistic encoding circuit for digital words of variable length for coding the output signal of the transcoding circuit, a buffer memory circuit for storing the words of the statistic encoding circuit and for supplying them to the output of said arrangement and an occupation measuring circuit for supplying occupation information of the buffer memory circuit said arrangement also comprising a combination member for supplying control information in response to the activity information and the occupation information, characterized in that the combination member comprises comparison means for comparing the activity information with threshold information in order to supply the control information, and combination circuits for supplying the threshold information in response to the occupation information and preestablished threshold information.

2. A differential pulse code modulation encoding arrangement as claimed in Claim 1, for which the occupation information is obtained in the form B(T) corresponding to the degree of filling of the buffer memory circuit, characterized in that the combination member comprises a calculation circuit for forming at instants $i_T$ with

$$i = -\infty, ..., T-2, T-1, T:$$
$$\alpha(T+1) = \alpha(T)-k.\{\rho B(T) + [B(T)-B(T-1)]\}$$
$$\text{where } k = [\alpha(T)-\alpha(T-1)]/[B(T)-2B(T-1)+B(T-2)]$$

and $\rho$ is a damping coefficient whose value may be equal to 0.5
and in that the combination circuits are multipliers for forming the products of the preestablished threshold information with this value $\alpha$.

3. A modulation decoding arrangement associated with an encoding arrangement as claimed in any one of Claims 1 and 2, in which means are provided for transmitting decoding information derived from the occupation information, characterized in that it comprises a circuit for extracting the decoding information, a decoder for decoding the digital words of variable length, a reception transcoding circuit for reestablishing the transcoding of the transmission transcoding circuit as a function of reception control information, an adder circuit for adding the output signal of the reception transcoding circuit to the signal supplied by a reception prediction circuit and for thus supplying the decoded signal on the one hand to the user and on the other hand to the input of the reception prediction circuit, a reception activity measuring circuit and a combination member for supplying the reception control information in response to the activity information and the occupation information.

## Patentansprüche

1. Kodierer für Differenz-Pulskode-Modulation mit einem Eingang zum Empfangen des zu kodierenden Signals, einer Differenzschaltung zum Liefern eines durch eine bestimmte Anzahl binärer Elemente gebildeten, die Differenz zwischen dem zu kodierenden Signal und einem Voraussagesignal darstellenden Differenzsignals, einem Sendevoraussagekreis zum Liefern dieses Voraussagesignals, einem Sendetranskodierkreis zum Verringern der Anzahl binärer Elemente der Differenzschaltung in Abhängigkeit von einer Steuerinformation zum Bestimmen eines aus einer Anzahl vorbestimmter Transkodierkennzeichen, einem Aktivitätsmeßkreis zum Liefern einer Aktivitätsinformation, einem Statistikkodierkreis für digitale Wörter veränderlicher Länge zum Kodieren des Ausgangssignals des Transkodierkreises, einem Pufferspeicherkreis zum Speichern der Wörter des Statistikkodierkreies und zum Liefern derselben zu dem Ausgang des genannten Kodierers, und einem Besetzungsmeßkreis zum Liefern einer Besetzungsinformation von dem Pufferspeicherkreis, wobei der genannte Kodierer außerdem ein Kombinierelement aufweist zum Liefern der Steuerinformation in Antwort auf die Aktivitätsinformation und der Besetzungsinformation, dadurch gekennzeichnet, daß das Kombinierelement Vergleichsmittel aufweist zum Vergleichen der Aktivitätsinformation mit Schwelleninformationen um auf diese Weise die Steuerinformation zu liefern, sowie Kombinierkreise zum Liefern der Schwelleninformationen in Antwort auf die Besetzungsinformation und die vorbestimmten Schwelleninformationen.

2. Kodierer für Differenz-Pulskode-Modulation nach Anspruch 1, für den die Besetzungsinformation in der Form B(T) entsprechend dem Füllungsgrad des Pufferspeicherkreises erhalten wird, dadurch gekennzeichnet, daß das Kombinierelement einen Rechenkreis aufweist zum Bilden zu den Zeitpunkten iτ mit

$i = \infty, ..., T-2, T-1, T:$

$\alpha(T+1) = \alpha(T) - k.\{\rho B(T) + [B(T) - B(T-1)]\}$

wobei $k = [\alpha(T) - \alpha(T-1)]/[B(T) - 2B(T-1) + B(T-2)]$

und ρ ein Dämpfungskoeffizient ist, dessen Wert gleich 0,5 sein kann,
und daß die Kombinierkreise Multiplikationskreise sind zum Liefern der Produkte aus den vorbestimmten Schwelleninformationen mit ihrem Wert ρ.

3. Differenz-Modulationsdekodierer zum Zusammenarbeiten mit einem Kodierer nach Anspruch 1 oder 2, in dem Mittel vorgesehen sind zum Übertragen einer von der Besetzungsinformation abgeleiteten Dekodierinformation, dadurch gekennzeichnet, daß er einen Dekodierinformationsextraktionskreis aufweist, einen Dekodierer zum Dekodieren der digitalen Wörter veränderlicher Länge, einen Empfangstranskodierkreis zum abhängig von einer Empfangssteuerinformation Wiederherstellen der Transkodierung des Sendetranskodierkreises, einen Addierkreis zum Addieren des Ausgangssignals des Empfangstranskodierkreises mit dem von einem Empfangsvoraussagekreis gelieferten Signal sowie zum Liefern des dekodierten Signals, einerseits zum Benutzer und andererseits zum Eingang des Empfangsvoraussagekreises, einen Empfangsaktivitätsmeßkreis und ein Kombinierelement zum Liefern der Empfangssteuerinformation in Antwort auf die Aktivitätsinformation und die Besetzungsinformation.

FIG. 1

EP 0 246 701 B1

# FIG. 2

EP 0 246 701 B1

# FIG. 3

# FIG. 4

EP 0 246 701 B1

# FIG. 6

# FIG. 5